# EUROPÄISCHE PATENTSCHRIFT

(11) **EP 0 596 208 B1**
(45) Veröffentlichungstag und Bekanntmachung des Hinweises auf die Patenterteilung: **06.08.1997**
(21) Anmeldenummer: 93113784.8
(22) Anmeldetag: 28.08.1993
(51) Int. Cl.: H03F 1/52, H03G 1/00

(54) **Audio-Verstärker mit automatischer Lautstärkenreduzierung nach thermischer Sicherheitsabschaltung**
Audio amplifier with automatic reduction of amplification after thermal protection switching
Amplificateur audio avec réduction de gain automatique après la mise en fonction de la protection thermique

(30) Priorität: 04.11.1992 DE 9215012 U
(43) Veröffentlichungstag der Anmeldung: 11.05.1994
(73) Patentinhaber: GRUNDIG Aktiengesellschaft, 90762 Fürth (DE)
(72) Erfinder: Förster, Wilfried, GRUNDIG E.M.V., D-90748 Fürth (DE)

(56) Entgegenhaltungen:
- EP-A- 0 292 105
- DE-U- 9 215 012
- ELEKTRONIK Bd. 31, Nr. 16 , August 1982 , MUNCHEN DE Seiten 27 - 29 J. LAMBOLEY '"Intelligenter " Baustein steuert und schützt Leistungstransistor'
- PATENT ABSTRACTS OF JAPAN vol. 012, no. 168 (E-611)20. Mai 1988 & JP-A-62 278 808 (MATSUSHITA ELECTRIC)
- PATENT ABSTRACTS OF JAPAN vol. 006, no. 123 (E-117)8. Juli 1982 & JP-A-57 050 113 (MIYASHITA KOGYO)

## Beschreibung

Die Erfindung betrifft einen Audioleistungsverstärker, der bei thermischer Überlastung durch Abtrennen der Last oder durch Unterbrechen der Spannungsversorgung vorübergehend außer Betrieb gesetzt wird.

Nach dem Stand der Technik ist es bekannt, einer Übersteuerung der Endstufe und gleichzeitig einer Überhitzung der Endstufentransistoren durch eine stetige Bedämpfung des Eingangssignals entgegenzuwirken. So offenbart die DE-PS 21 23 892 eine Schaltungsanordnung, bei der eine aus dem Ausgangsstrom des Verstärkers abgeleitete erste Regelspannung, eine aus der Ausgangsspannung des Verstärkers abgeleitete zweite Regelspannung und eine mit Hilfe eines Temperatursensors aus der Erwärmung des Kühlkörpers abgeleitete dritte Regelspannung zur Steuerung eines Dämpfungsgliedes am Verstärkereingang verwendet werden.

Die EP-PS 0 292 105 beschreibt eine Schutzschaltung, bei der über einen Temperatursensor die Vorspannung eines Brückenverstärkers zur Einengung der maximalen Ausgangsspannung verändert wird. Über einen zusätzlichen Clipping-Detektor wird ein elektronischer Lautstärkesteller zur Dämpfung des Eingangssignals solange nachgesteuert, bis die Ausgangsspannung nicht mehr in ihrer Amplitude beschnitten ist.

Schließlich ist aus der EPA 0 399 276 eine Temperaturschutzschaltung für einen Leistungsverstärker bekannt, bei dem, gesteuert von einem Temperatursensor, die Verstärkung einer Vorstufe verändert wird, wobei das Steuersignal über ein Oder-Glied mit dem Signal eines Clipping-Detektors verknüpft sein kann, um ein klirrfaktorarmes Ausgangssignal zu erzielen.

Die vorgenannten Regelschaltungen haben den Nachteil, daß zur Erzielung einer stetigen Bedämpfung der Eingangsspannung ein nicht unerheblicher Schaltungsaufwand in Kauf genommen werden muß. Will man diesen Aufwand vermeiden, so kann man, dem Stand der Technik entsprechend, nur einen mit der Kühlfläche der Leistungstransistoren kontaktierten Thermoschalter vorsehen, mit dessen Hilfe die Endstufe bei Überhitzung vorübergehend außer Betrieb gesetzt wird. Dabei wirkt aber besonders störend, daß nach einer Abkühlungsphase der Verstärker mit unverminderter Lautstärke plötzlich wieder in Funktion tritt.

Es ist deshalb Aufgabe der vorliegenden Erfindung, einen Audio-Leistungsverstärker mit thermischer Sicherheitsabschaltung derart zu gestalten, daß das selbsttätige Wiedereinschalten des Verstärkers zwar hörbar bleibt, aber für den Gerätebenutzer nicht erschreckend wirkt.

Diese Aufgabe wird durch eine Schaltungsanordnung mit den kennzeichnenden Merkmalen des Anspruchs 1 gelöst. Unteranspruch 2 offenbart eine vorteilhafte Ausgestaltung der beanspruchten Schaltung.

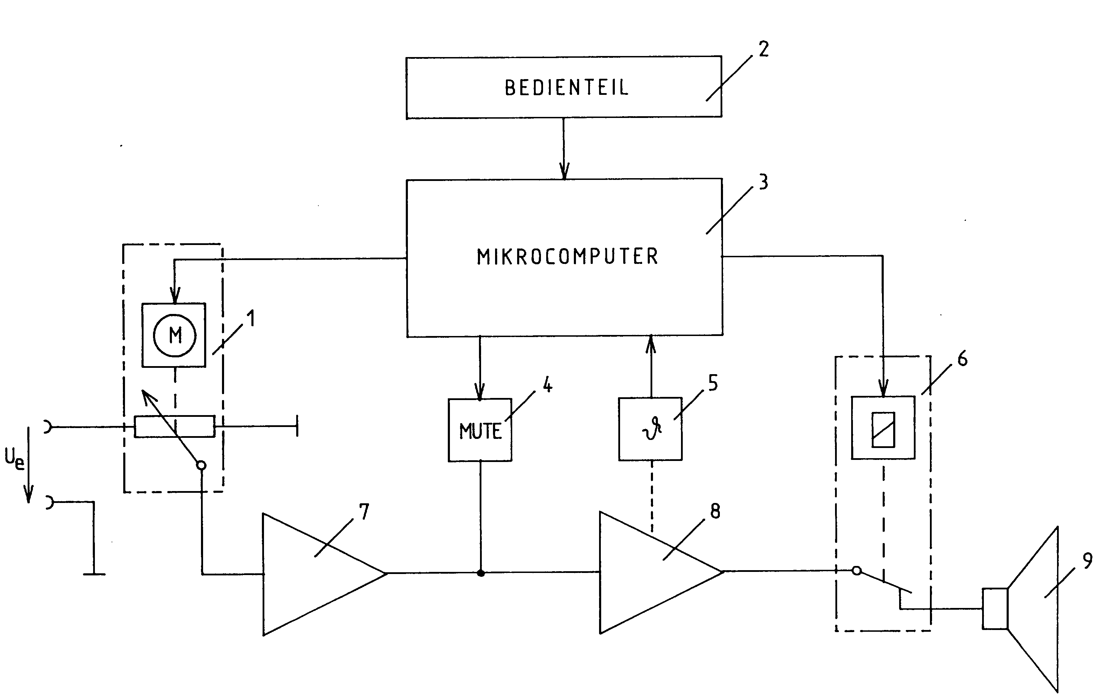

Anhand der Zeichnung wird die Erfindung nachfolgend beschrieben.

Die Figur zeigt das Blockschaltbild eines mit den Merkmalen des Anspruchs 1 versehenen Leistungsverstärkers. In an sich bekannter Weise besteht dieser Leistungsverstärker aus der Treiber-Vorstufe 7 und der Endstufe 8. Ein Mikrocomputer 3 verarbeitet die vom geräteeigenen Bedienteil 2 kommenden Steuerbefehle und dient gleichzeitig als Dekodierer einer nicht dargestellten Fernbedienungseinrichtung. Entsprechend der Befehlseingabe des Gerätebenutzers über das Bedienteil 2 steuert der Mikrocomputer 3 den motorgetriebenen oder elektronischen Lautstärkesteller 1, über den das Verstärkereingangssignal Uₑ der Treiber-Vorstufe 7 zugeführt wird. Am Ausgang dieser Treiber-Vorstufe sorgt die vom Mikrocomputer 3 gesteuerte Mute-Schaltung 4 dafür, daß außerhalb des regulären Verstärkerbetriebes der Eingang der Endstufe 8 kurzgeschlossen ist. Dies gilt vor allem für den Zeitablauf während des Umschaltens der Signalquellen oder während der Totzeit nach Ansprechen der Übertemperatursicherung.

Die von der Endstufe 8 verstärkte NF-Signalspannung wird über den Ruhekontakt des Lautsprecher-Relais 6 dem Lautsprecher 9 zugeführt. In direktem Kontakt mit dem Kühlblech der Endstufe 8 steht der Temperatursensor 5, der bei Überschreitung eines vorgegebenen Schwellwertes ein Steuersignal an den Mikrocomputer 3 liefert. Aufgrund dieses Steuersignals betätigt der Mikrocomputer 3 das Lautsprecherrelais 6 und trennt den Lautsprecher 9 vom Ausgang der Endstufe 8 ab. Wahlweise kann auch über eine in der Zeichnung nicht dargestellte Schalteinrichtung die Versorgungsspannung der Endstufe 8 abgeschaltet werden.

Mit dem Auslösen der thermischen Sicherheitsabschaltung gibt der Mikrocomputer 3 gleichzeitig an den Lautstärkesteller 1 den Befehl, die Dämpfung des Verstärkereingangssignals um den Wert Δ A (beispielsweise: 20 dB) zu erhöhen. Damit wird vermieden, daß beim Wiedereinschalten der Endstufe der Verstärker nach einer Abkühlphase mit unvermindert hoher Lautstärke plötzlich seinen Betrieb wieder aufnimmt.

Sollte trotz reduzierter Aussteuerung der Verstärker, bedingt durch ungünstige Umgebungstemperaturen, erneut thermisch überlastet werden, so wird der Mikrocomputer 3 den Lautstärkesteller 1 bei jedem Abschaltvorgang jeweils um den gleichen Betrag Δ A zurückstellen, bis ein vorgebbarer maximaler Dämpfungswert erreicht ist, der noch eine Restlautstärke gewährleistet.

## Patentansprüche

1. Audio-Leistungsverstärker mit einem elektronischen oder motorgetriebenen Steller zur Veränderung der Wiedergabelautstärke, mit einer als Mikrocomputer ausgebildeten Steuerschaltung zur Betätigung des Lautstärkestellers und mit einem Temperatursensor zum Feststellen einer thermischen Überlastung des Verstärkers,
**dadurch gekennzeichnet,** daß Mittel vorhanden sind, so daß nach Abschaltung des als Last betriebenen Lautsprechers (9) infolge thermischer Überlastung der Endstufe (8) des Leistungsverstärkers der Lautstärkesteller (1) um einen vorgegebenen Dämpfungswert (ΔA) vom Mikrocomputer (3) automatisch zurückgesetzt wird, wodurch ein plötzlicher Toneinsatz mit hoher Lautstärke beim selbsttätigen Wiederanschalten des Lautsprechers nach Abkühlung des Verstärkers vermieden wird.

2. Audio-Leistungsverstärker nach Anspruch 1,
**dadurch gekennzeichnet,** daß der Mikrocomputer (3) den Lautstärkesteller (1) für den Fall, daß nach dem Wiederanschalten des Lautsprechers (9) erneut eine thermische Überlastung der Endstufe (8) eintritt, wiederholt um den gleichen Dämpfungsbetrag (ΔA) zurücksetzt, bis ein vorgebbarer maximaler Dämpfungswert erreicht ist, der noch eine Restlautstärke gewährleistet.

## Claims

1. Audio power amplifier having an electronic or motor-driven controller for varying the reproduction volume, having a control circuit designed as a microcomputer for actuating the volume controller and having a temperature sensor for detecting thermal overloading of the amplifier, characterized in that means are present which are such that, after the loudspeaker (9), which is operated as a load, has been disconnected as a consequence of thermal overloading of the output stage (8) of the power amplifier, the microcomputer (3) automatically resets the volume controller (1) by a specified attenuation value (ΔA), as a result of which a sudden sound restoration at high volume is avoided when the loudspeaker is automatically reconnected after the amplifier has cooled.

2. Audio power amplifier according to Claim 1, characterized in that, if a thermal overloading of the output stage (8) again occurs after reconnecting the loudspeaker (9), the microcomputer (3) repeatedly resets the volume controller (1) by the same attenuation value (ΔA) until a specifiable maximum attenuation value which still ensures a residual volume is reached.

## Revendications

1. Amplificateur de puissance audio comportant un régulateur électronique ou entraîné par un moteur servant à modifier une intensité acoustique de reproduction, comportant un circuit de commande agencé sous la forme d'un micro-ordinateur et servant à actionner le régulateur d'intensité acoustique, et un capteur de température servant à déterminer une surcharge thermique de l'amplificateur, caractérisé en ce que des moyens sont prévus de telle sorte qu'après le débranchement du haut-parleur (9) fonctionnant en tant que charge sous l'effet d'une surcharge thermique de l'étage final (8) de l'amplificateur de puissance, le régulateur d'intensité acoustique (1) est rétrogradé automatiquement, par le micro-ordinateur (3), d'une valeur d'affaiblissement prédéterminée ( A), ce qui permet d'éviter une brusque délivrance d'un son avec une intensité acoustique élevée lors du rebranchement automatique du haut-parleur, après refroidissement de l'amplificateur.

2. Régulateur de puissance audio selon la revendication 1, caractérisé en ce que le micro-ordinateur (3) rétrograde d'une manière répétée, de la même valeur d'affaiblissement ( A), le régulateur d'intensité acoustique (1) dans le cas où, après le rebranchement du haut-parleur (9), une surcharge thermique de l'étage final (8) apparaît à nouveau, jusqu'à ce que soit atteinte une valeur d'affaiblissement maximale pouvant être prédéterminée, qui garantit encore une intensité acoustique résiduelle.
